# EUROPEAN PATENT APPLICATION

(11) **EP 4 841 271 A1**
(43) Date of publication of application: **18.11.2026**
(21) Application number: 26174046.8
(22) Date of filing: 22.04.2026
(51) Int. Cl.: G01R 15/18, G01R 19/25, G01R 22/06, G01R 22/10

(54) **SCALABLE AND CONFIGURABLE DIGITAL METERING DEVICES**

(30) Priority: 12.05.2025 US 202519205570
(71) Applicant: Schneider Electric USA, Inc., Boston, MA 02108 (US)
(72) Inventor: JAKUPI, Andi, Boston, 02108 (US); VARGAS RIOS, Leon Maximino, Boston, 02108 (US)
(74) Representative: Openshaw & Co.

(57) **Abstract**

The present disclosure is directed to methods and system for monitoring the current of a circuit comprising conversion of an analog current transformer signal (112) to a digital signal adjacent to the point of measurement of the current transformer (102). The present disclosure is further directed to a system where a current transformer (102) and circuity configured to convert the analog current signal (112) from the current transformer (102) to a digital voltage signal (114) are contained within a single enclosure (301).

## Description

### FIELD

The present disclosure relates to the field of digital metering devices and systems for monitoring current in an electrical circuit (e.g., systems including a current transformer).

### BACKGROUND

Current transformers are generally available in the market at the present time as analog current transformers. That is, the current transformers measure current in an electrical circuit and produce an alternating current that is an analog current signal. Other current transformers have an internal burden resistor that converts the analog current signal to an analog voltage signal. Many energy monitoring devices or systems employ such analog current transformers.

Analog signals present a number of issues related to accuracy, durability, interference, etc. Solutions currently advertised as producing a digital signal from a current transformer do not truly produce a commercially acceptable digital signal that corresponds to the measured analog signal of the current transformer, perform the conversion to a digital signal at a location far removed from the point of measurement (i.e. such that the analog signal is subject to interference, crosstalk, etc. prior to conversion), or require digital hardware that is only capable of operating in a small current range.

Therefore, a need remains for digital energy monitoring systems, devices, and methods that overcome the problems previously encountered in the industry and that are readily scalable and configurable. In particular, there remains a need for improved systems and methods for monitoring current in an electrical circuit and/or determining a status of an electrical circuit.

### SUMMARY

One aspect of the present disclosure is directed to a system for monitoring current in an electrical circuit. The system comprises a current transformer configured to be coupled to the electrical circuit for monitoring, wherein the current transformer is configured to produce an analog current signal representative of the current in a portion of the electrical circuit to which the current transformer is coupled; and conversion circuity configured to receive the analog current signal and output a digital voltage signal corresponding to the received analog current signal. In certain aspects, the current transformer and conversion circuity are contained within a single enclosure.

Other aspects of the present disclosure are directed to a method for determining a status of an electrical circuit. The method comprises sensing, by a current transformer configured to be coupled to the electrical circuit, current in the electrical circuit, wherein the current transformer is configured to produce an analog current signal representative of the current in a portion of the electrical circuit to which the current transformer is coupled; transmitting the analog current signal to conversion circuity configured to receive the analog current signal and output a digital voltage signal corresponding to the received analog current signal, wherein the current transformer and the conversion circuitry are housed in a single enclosure; and transmitting the digital voltage signal to a communications unit, wherein the communications unit outputs a communications output representative of the digital voltage signal.

Still further aspects of the present disclosure are directed to a system for monitoring current in an electrical circuit. The system comprises a plurality of current transformers each configured to be coupled to the electrical circuit for monitoring, wherein each of the plurality of current transformers are configured to produce an analog current signal representative of the current in a respective portion of the electrical circuit to which the current transformer is coupled; and conversion circuity configured to receive each analog current signal and output digital voltage signals corresponding to each received analog current signal. In certain aspects, the conversion circuity is adjacent to the plurality of current transformers.

Additional aspects of the present disclosure are directed to methods and systems for communication. The methods and systems for communication comprise providing a plurality of current transformer systems, each configured to produce a digital voltage signal and/or produce a plurality of communications outputs representative of the digital voltage signals, and a manager device configured to synchronize the communication of each of the plurality of digital voltage signals and/or communications outputs along a single communications bus.

Other objects and features will be in part apparent and in part pointed out hereinafter.

### BRIEF DESCRIPTION OF THE DRAWINGS

FIG. 1 illustrates a system for monitoring current in an electrical circuit of one aspect of the present disclosure utilizing a current transformer and conversion circuity configured to receive an analog current signal and output a digital voltage signal corresponding to the received analog current signal.
FIGS. 2A and 2B illustrate the impacts on diagnostic testing (i.e. measurement of an injection signal) when the system comprises a closed core (FIG. 2A) vs. an open core (FIG. 2B).
FIG. 3 illustrates one embodiment of a system for monitoring current in an electrical circuit wherein the system is contained within a single enclosure.
FIG. 4 provides a detailed illustration of one embodiment of a system for monitoring current in an electrical circuit of the present disclosure comprising a single current transformer.
FIG. 5A shows an alternative flow diagram of one embodiment of a system for monitoring current in an electrical circuit of the present disclosure comprising a single current transformer and a microcontroller unit (MCU).
FIG. 5B shows a diagram of the processing blocks for an MCU unit as shown in FIG 5A.
FIG. 6 illustrates one embodiment of a system for monitoring current in an electrical circuit of the present disclosure comprising two current transformers operating simultaneously.
FIG. 7 illustrates an alternative configuration of one embodiment of a system for monitoring current in an electrical circuit of the present disclosure comprising two current transformers operating simultaneously.
FIGS. 8A and 8B illustrate exemplary configurations of systems for monitoring current in an electrical circuit comprising two current transformers
FIG. 9 illustrates one embodiment of a system for monitoring current in an electrical circuit of the present disclosure comprising two pairs of current transformers operating simultaneously.
FIG. 10 illustrates communication of a digital voltage signals from multiple devices wherein the devices are connected in the same communications bus.
FIG. 11 illustrates device discovery and synchronization for waveform sample acquisition across multiple current transformers.
FIG. 12 is in an exemplary flow diagram of the steps taken by a manager device for device discovery and synchronization for waveform sample acquisition across multiple current transformers.
FIG. 13 illustrates a data flow diagram between a manager device and multiple sensor devices.
FIG. 14 illustrates a device discovery and synchronization mechanism for three sensor devices, with the offset times show graphically.
FIG. 15 illustrates a system for periodic synchronization communications.

Corresponding reference characters indicate corresponding parts throughout the drawings.

### DETAILED DESCRIPTION

Present systems for monitoring current in an electrical circuit generally utilize analog current signals produced by analog current transformers. Analog current transformers measure current at varying degrees of accuracy, for example, from 5% up to 0.5% based on NEMA ANSI C12.20 (moving to C12.1), IEC 61557-12 or IEEE C57.13 standards. However, analog current signals are more susceptible to exposure to external noises, crosstalk and variabilities due to the other wires routed in a panel and conductors nearby.

In some current configurations, the analog current signal of a current transformer is conditioned and converted to a digital signal at energy measuring devices (ASIC) or converted with analog-to-digital converter(s) and processed digitally at a microcontroller at the monitor. However, this leaves the entire length of the system (e.g., the wires) from the current transformer to the energy measuring devices and/or monitor exposed to external noises, crosstalk and variabilities due to the other wires routed in a panel and conductors nearby. In order to make this design function, the system must be adjusted to specific calibration parameters. This reduces the universe of different current transformer subassemblies that can be connected to the system without compromising the accuracy.

Additionally, the analog current signal of every current transformer secondary requires its own pair of wires. Thus, when several circuits are being measured, it may be difficult to install and maintain code compliance due to many cables being present together inside an enclosure.

Further configurations utilize clamp current transformers with Hall Effect sensors of low accuracy that require digital hardware and work only on small current ranges. The larger circuits in such a configuration use conventional analog current transformers with submodule interfaces that require an individual connector for each current transformer. This configuration suffers from a number of defects and fails to achieve the benefits of embodiments of the present disclosure.

Additional configurations have air core designs (i.e. Rogowski coils) with a nearby amplifier for the secondary signal. However, these designs are neither feasible for clamp-on constructions, nor for applications where the primary current wire position is variable, such is in an electrical panel.

Other current configurations conduct voltage readings in the same enclosure as the current sensors, such that there is an energy calculation digital circuitry at every point where current is measured. This approach requires exceedingly careful placement of wiring to ensure contactless voltage sensing and maintain the energy monitoring accuracy. This is generally not economical given that the voltage in the bus inside a panel can be considered common in certain situations.

Still further current configurations are advertised as digital, but are in fact analog current transformer systems. For example, an analog current transformer that, when a given threshold of a secondary current is passed, activates a transistor that changes a logic (digital) state 0 to 1. Such a configuration does not result in a digital current signal that corresponds to the true current measurement signal.

For each of these reasons, a need remains in the industry for a system for monitoring current in an electrical circuit wherein a digital signal can be prepared and processed immediately adjacent to the point of measurement. This reduces the length of time that the measured current signal is subject to external interference (i.e. the length of the wire or conductor that transmits the analog signal prior to conversion to a digital signal), and results in an overall more robust digital signal that can be manipulated and analyzed in a number of unique ways.

The present disclosure is directed in certain embodiments to digital energy monitoring systems, devices, and methods that overcome the previously problems discussed above. Further embodiments of the present disclosure are directed to current monitoring systems, devices, and methods that overcome these problems. For example, systems, devices, and methods for determining a status of an electrical circuit. Certain embodiments described herein utilize analog-to-digital converter(s) near a current transformer to improve the reliability, durability, and processability of the measurements made by the current transformer.

In one embodiment, the present disclosure is directed to systems and methods comprising current transformers wherein conversion of the analog current signal produced by the current transformer to a digital signal is performed at a location adjacent to the current transformer, thus reducing these variabilities and influence of external noise. Additional embodiments are directed to communicating the resulting digital signal to a monitor for evaluation and/or further processing. In alternative embodiments, conversion of the analog current signal produced by the current transformer and processing of the resulting digital signal are performed at a location adjacent to the metering device (e.g., by a microcontroller), and subsequently communicated to a monitor via a digital communications unit. Still further embodiments described herein are directed to systems for monitoring current in an electrical circuit comprising a current transformer and conversion circuity configured to receive an analog current signal and output a digital voltage signal corresponding to the received analog current signal, wherein the current transformer and the conversion circuity are present within a single enclosure.

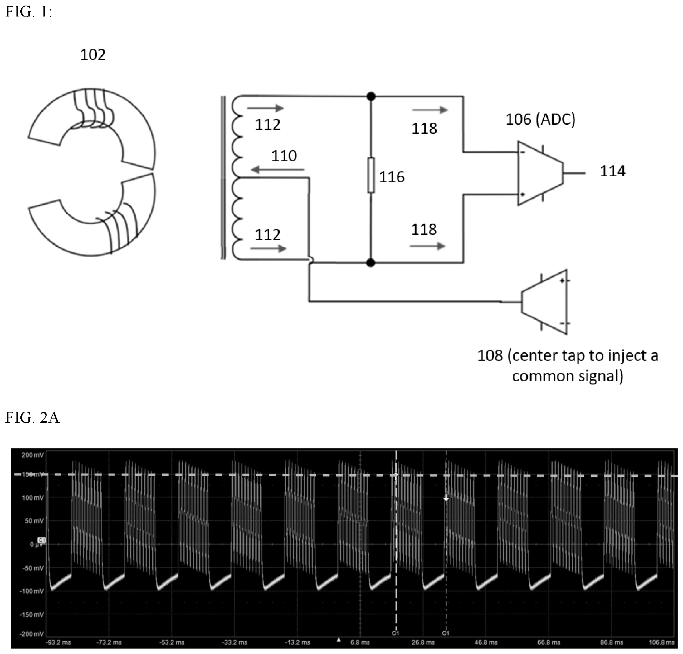

Turning now to the figures, FIG. 1 illustrates a system for monitoring current in an electrical circuit of one aspect of the present disclosure utilizing a current transformer. A current transformer 102 is coupled to an electrical circuit (e.g., wire or device) to be measured and is configured to produce an analog current signal 112 representative of the current in a portion of the electrical circuit to which the current transformer is coupled. The analog current signal 112 is then directed through conversion circuity configured to receive the analog current signal and output a digital voltage signal corresponding to the received analog current signal. As shown in FIG. 1, analog current signal 112 is directed through a burden resistor 116 configured for conversion of the analog current signal into an analog voltage signal 118. The voltage output is proportional to the primary current based on a specific transfer function. The analog voltage signal 118 is subsequently directed to an analog-to-digital converter (ADC) 106 configured to receive the analog voltage signal and output a digital voltage signal 114.

A current transformer 102 as shown in FIG. 1 may consist of an iron core with an airgap for clamps to open and close. The system requires a burden resistor to convert the current to a voltage and avoid a current transformer open secondary with the associated high voltage hazards. That is, by having a burden resistor near the secondary winding of the current transformer, the conversion from current to voltage is better controlled and isolated from variabilities of the cables or antenna effects. A current transformer 102 in the form of a clamp, and the associated system, allows for two separate coils (secondaries) for each iron core and the common connection between them to serve as a center tap which can be used for signal injection. The other part of the winding can be used for the overall current measurement. The center tap can be used to inject an equally balanced signal to measure the voltage on the output from each side of the coils. In certain embodiments, a digital-to-analog conversion or pulse width modulation (PWM) unit may be utilized to inject a signal into the current transformer and evaluate the output. As shown in FIG. 1, a pulse width modulation unit 108 directs a signal 110 using a center tap to inject a common signal for each coil and measure the injection signal. In this way, it is possible to conduct a diagnostic test utilizing the core, secondary or disbalance measurements.

An open core may be present when the installer does not fully close the current transformer and allows an air-gap between the core. Since the magnetic core concentrates the flux to increase the induction current, any air gap will reduce this magnetic flux and therefore reduce the induced output from the secondary coils. In certain embodiments discussed in further detail herein, the presence of an open core can be ascertained when the hardware injects a known signal via a pulse wave modulation unit with a known frequency and amplitude waveform. The signal can then be measured and compared to the known output. Similar techniques can be used to detect a damaged secondary coil of a current transformer, where the output would be non-symmetric and/or missing.

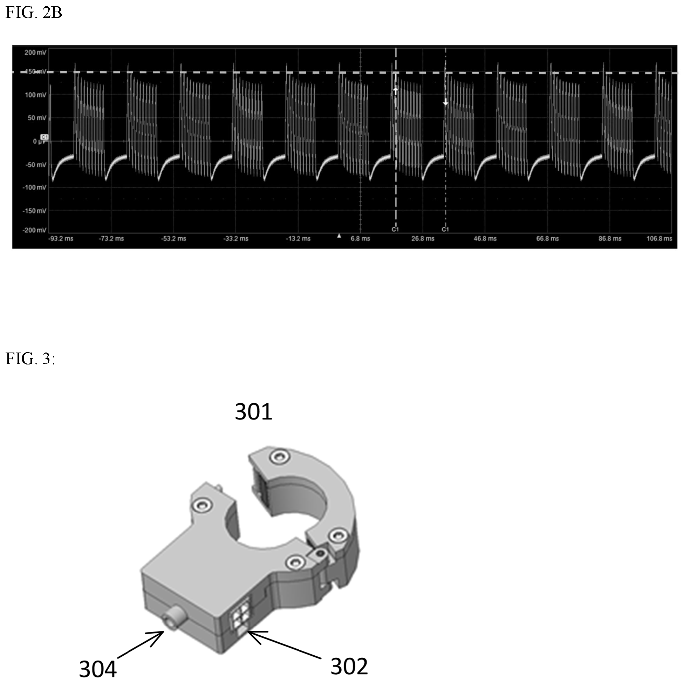

FIGS. 2A and 2B show examples of the impact on such diagnostic testing (i.e. measurement of an injection signal) when the system comprises a closed core (FIG. 2A) vs. an open core (FIG. 2B). When the signal is injected in the open core, the measured signal is much weaker as compared to when the signal is injected in a core that is closed. Thus, the results of FIGS. 2A and 2B demonstrate the impact that may be had on detection/diagnostics of the current transformers and systems described elsewhere herein, when the current transformers are not clamped correctly and/or if the secondary coil is broken. As discussed elsewhere herein, a further processing or diagnostic steps using this signal may be performed to notify the use that a current transformer needs to be serviced or replaced.

In certain embodiments, the system of FIG. 1 may further comprise one or more of a low pass filter unit, an amplifier unit, a processing unit, a communications unit, a control and configuration unit, a diagnostic unit, or any combination thereof. For example, as described in further detail below, in one embodiment, the digital voltage signal 114 may be transmitted to one or more of a processing unit, communication unit, control and configuration unit, or diagnostics unit. As described in further detail below, the digital voltage signal may be transmitted such that a control and configuration unit directs the system to conduct a diagnostic scheme.

Having discussed an exemplary configuration of a system for monitoring current in an electrical circuit of the present disclosure, FIG. 3 further illustrates one embodiment wherein the system is contained within a discrete enclosure.

FIG. 3 shows one embodiment of the present disclosure wherein the system 301 for monitoring current in an electrical circuit comprises a current transformer component that is represented by the open clamp and is configured to close around the circuit to be measured (e.g., a wire), a bus connector 302 for digital communication and an optional port 304 for connection to other current transformers and/or to provide power to the system 301.

As described in further detail below, the system 301 may in certain embodiments comprises the current transformer, a burden resistor, and an analog-to-digital converter (ADC) within a single enclosure. The system 301 may comprise certain other components such as a processing unit, communications unit, control and configuration unit, diagnostics unit, etc. either within the signal enclosure or external to the enclosure.

In one embodiment of FIG. 3, the current transformer is configured to produce an analog current signal representative of the current in a portion of the electrical circuit to which the current transformer is coupled, a burden resistor present within the enclosure of the system 301 is configured to receive the analog current signal and output an analog voltage signal, and an ADC present within the enclosure of the system 301 is configured to receive the analog voltage signal and output a digital voltage signal. This digital voltage signal may be transmitted away from the system for further processing or evaluation via the bus connector 302. Alternatively, the system 301 may comprise a communications unit within the enclosure that generates a communications output representative of the digital voltage signal to be transmitted via the bus connector 302.

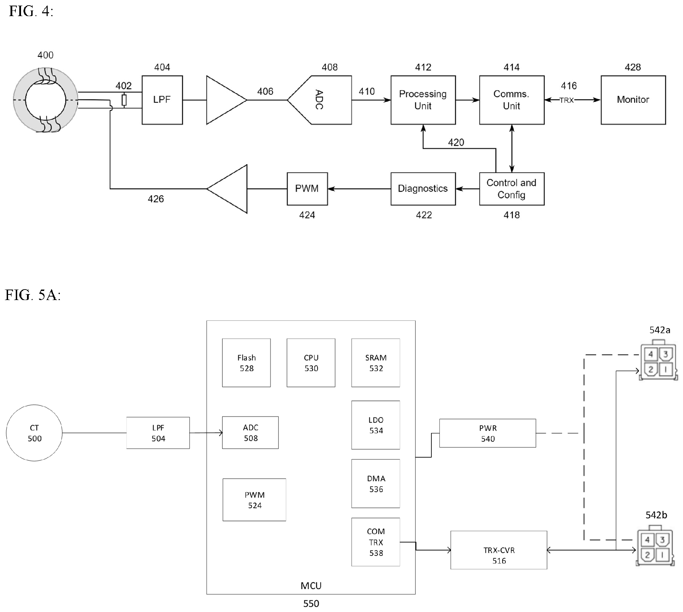

FIG. 4 provides a more detailed illustration of one embodiment of a system for monitoring current in an electrical circuit of the present disclosure comprising a single current transformer. Current transformer 400 is coupled to (e.g., clamped around) an electrical circuit for measurement. The current transformer is configured to produce an analog current signal, representative of the current in a portion of the electrical circuit to which the current transformer is coupled, which is directed to burden resistor 402. Burden resistor 402 is configured to receive the analog current signal and output an analog voltage signal. The analog voltage signal is subjected to a low pass filter 404 and the resulting filtered analog voltage signal 406 is directed to an ADC 408, wherein the ADC is configured to receive the filtered analog voltage signal and output a digital voltage signal 410. As shown in FIG. 4, the digital voltage signal 410 is directed to a processing unit for further processing.

Such further processing of the digital voltage signal may comprise any suitable processing techniques, including those discussed in further detail herein. In one embodiment, the processing may comprise utilizing the digital voltage signal from the ADC to calculate the total harmonic distortions (THD) of the signal. In another embodiment, the processing may comprise calculating the root mean square (RMS) at different rates. For example, 1 period (60Hz), 60 periods (1Hz), or more periods for an RMS reported every 5 seconds. Further embodiments may comprise processing that comprises waveform analysis of the signal(s). In another embodiment, processing comprises calibration and/or digital filtering of the signal(s). Still further embodiments comprise processing the signal(s) to generate other useful statistical values (e.g., DC offset, Pk-Pk values, etc.).

The signal resulting from the processing of unit 412 is directed to a communications unit 414. The communications unit is configured to interact with a transceiver 416 and generate communications outputs (e.g., a communications output representative of the digital voltage signal) or receive communications inputs. That is, the processed digital voltage signal resulting from unit 412 may be transmitted to a second location for monitoring or analysis. For example, the processed digital voltage signal may be transmitted via transceiver 416 to a monitor.

Alternatively or additionally, communications unit 414 may be configured to output a communications output representative of the digital voltage signal (e.g., processed digital voltage signal) to a control and configuration unit 418 present within the energy monitoring system. For example, in certain embodiments, the system of FIG. 4 may comprise components suitable for conducting a built-in self-test or diagnostic analysis of the current transformer or circuit being measured. An analog pulse 426 may be generated with a pulse width modulation unit 424 and digital-to-analog converter (DAC) to a test winding in the current transformer to test the measurement chain and/or the state of the core. Evaluation of the results of this test pulse initiated by the diagnostic unit 422 may be used to detect improper installation, open-clamps, or a compromised accuracy of the device. This information can then be communicated to a second location (e.g., via transceiver 416) for monitoring, analysis, or corrective maintenance. For example, a monitor 428 at a second location may be configured to receive the communications output(s), determine a status of the electrical circuit based on the communications output(s) received from the transceiver 416, and/or provide a diagnostic output (e.g., corrective instructions) in response to the determined status. In certain embodiments, the monitor may be any suitable electronic device that is external to the system (e.g., enclosure as illustrated in FIG. 3) and is configured to receive the communications output(s). For example, the monitor may comprise transceiver circuitry. In other embodiments, the monitor may comprise transceiver circuity and a microprocessor/microcontroller (i.e. to perform one or more of the functions described herein).

The configuration of the system illustrated in FIG. 4 allows for the system to provide computed measurement features such as RMS, THD and also waveform samples via programmable commands. Commands can be sent from a second location (e.g., a monitor or end user) via transceiver 416 to direct the system to compute certain calculations with the digital samples locally and send the data over the transceiver 416.

In certain embodiments, each of the components of the system for monitoring current in an electrical circuit illustrated in FIG. 4 are contained within a single enclosure.

FIG. 5A shows an alternative flow diagram of one embodiment of a system for monitoring current in an electrical circuit of the present disclosure comprising a single current transformer and a microcontroller unit (MCU). Similar to FIG. 4, 500 represents a single current transformer. The analog current signal resulting from the current transformer is directed to a low pass filter 404 and the resulting filtered analog voltage signal is directed to an ADC 508, wherein the ADC is configured to receive the filtered analog voltage signal and output a digital voltage signal.

A MCU is illustrated in FIG. 5A at 550. In the embodiment illustrated in FIG. 5A, the MCU 550 comprises an ADC 508, a flash memory 528, central processing unit (CPU) 530, static random-access memory (SRAM) 532, low-dropout (LDO) voltage regulator 534, direct memory access (DMA) unit 536, transceiver or communications unit 538, and a pulse width modulation unit 524. The pulse width modulation unit 524 allows for the introduction of a "test" signal to the current transformer 500, in order to more accurately capture anomalies in the current transformer and allow for increased accuracy of the current transformer measurements.

In certain embodiments of the present disclosure, the system for monitoring current in an electrical circuit comprises both a current transformer and a MCU. For example, the system for monitoring current in an electrical circuit may comprise both the current transformer and MCU within a single enclosure (e.g., as illustrated in FIG. 3). The embedded MCU may comprise circuity configured to convert and process the voltage signal, perform diagnostics on the current transformer and/or circuit being measured, independently perform configuration and control of the current transformer, and/or communicate information external to the system (e.g., a monitor at a second location). For example, the embedded MCU can generate a pulse with a PWM/DAC module to a test winding in the current transformers to test the measurement chain and the state of the core. With embedded firmware in the MCU, a built-in self-test for diagnostics, detection of improper installation, open-clamps, or a potential compromised accuracy can be undertaken and the results communicated to a monitor/end user for eventual maintenance and/or replacement. With such embedded firmware, the MCU can be configured to provide computed measurement features such as RMS, THD and also waveform samples via programmable commands. The embedded MCU may also comprise circuity configured to receive communications from a source external to the system (e.g., a monitor at a second location), and perform the desired function or step within the system. For example, a monitor can send commands and tell each MCU to compute certain calculations with the digital samples and send the data over the communication bus.

Data is transmitted to and from the MCU of the system via transceiver 516 and communication buses 542a and/or 542b as shown. Power is supplied to the MCU and communication buses via power unit 540.

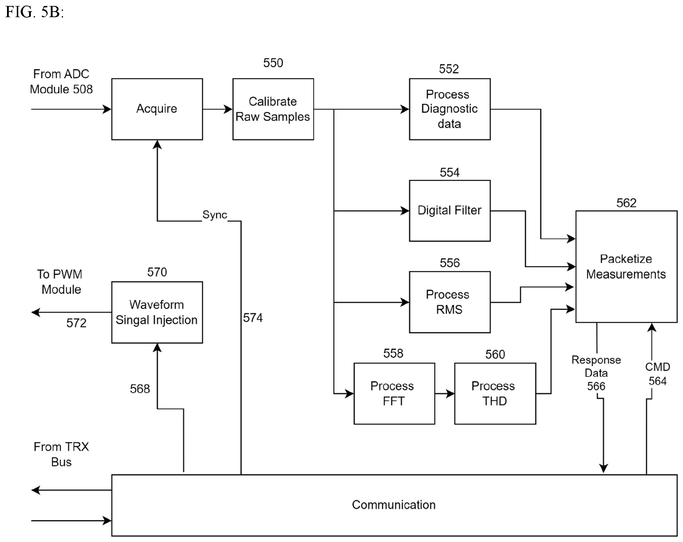

FIG. 5B further illustrates one embodiment of an MCU useful in the present disclosure (e.g., a MCU as shown in FIG. 5A). FIG. 5B illustrates the process steps that such a microcontroller unit would take, in one embodiment, to receive, process, and transmit the current transformer measurement.

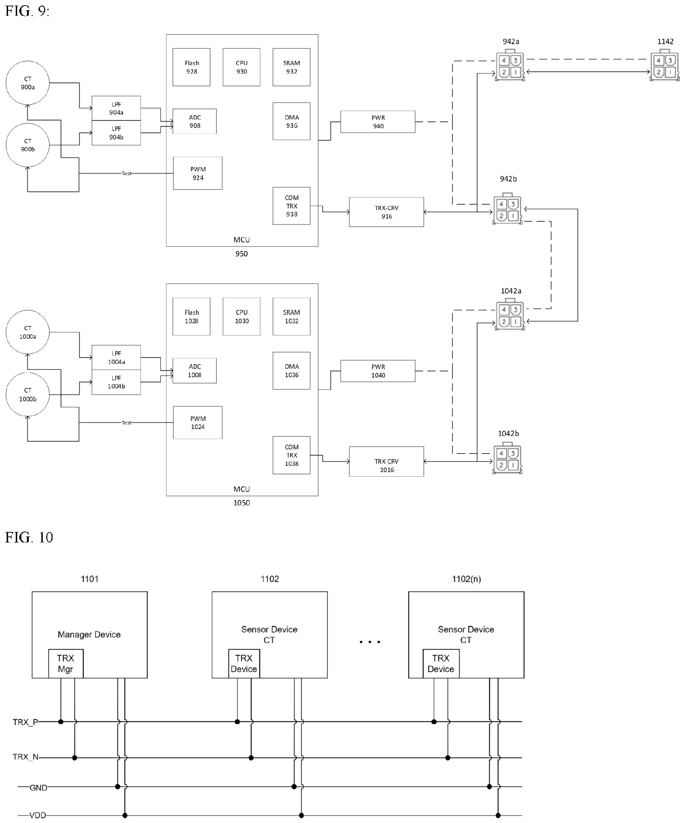

The digital voltage signal resulting from ADC 508 is acquired and calibrated at 550. For example, calibration of the signal to remove any inherent bias from the analog front end (e.g., a low pass filter and/or amplifier) and/or apply any gain or scaling of the measured values to convert them to desired units (e.g., amps (A) or mA). Following calibration of this digital voltage signal, the signal is processed by one or more of 552, 554, 556, 558, or 560. For example, the digital voltage signal may be processed to prepare a RMS value at 556, a fast Fourier transform (FFT) at 558, or a THD value at step 560. Alternatively, or additionally, the signal may be processed to glean certain diagnostic information at 552 or subjected to further digital filtering at 554. As described elsewhere herein (and illustrated in FIGS. 10-15), a CMD 564 may be sent to the MCU to request that one or more of steps 552-560 be taken. The results of the requested one or more of steps 552-560 are assembled into a "packet" at 562 and transmitted as a response 566 to the manager device (described in further detail below).

Following instructions 568 from the manager device, a waveform for signal injection may be prepared at 570 and directed to the pulse width modulation unit at 572. As described elsewhere herein (and illustrated in FIGS. 10-15), the MCU may receive a "Sync" signal 574 from a manager device and perform the functions as described below.

In embodiments described herein where the system comprises a current transformer and conversion circuitry configured to receive an analog current signal and output a digital voltage signal corresponding to the received analog current signal (e.g., MCU) within a single enclosure, further benefits may be realized by calibrating the system at the point of manufacturing and storing the calibration parameters within the memory of the MCU. This reduces the time and effort needed to install and use the described systems.

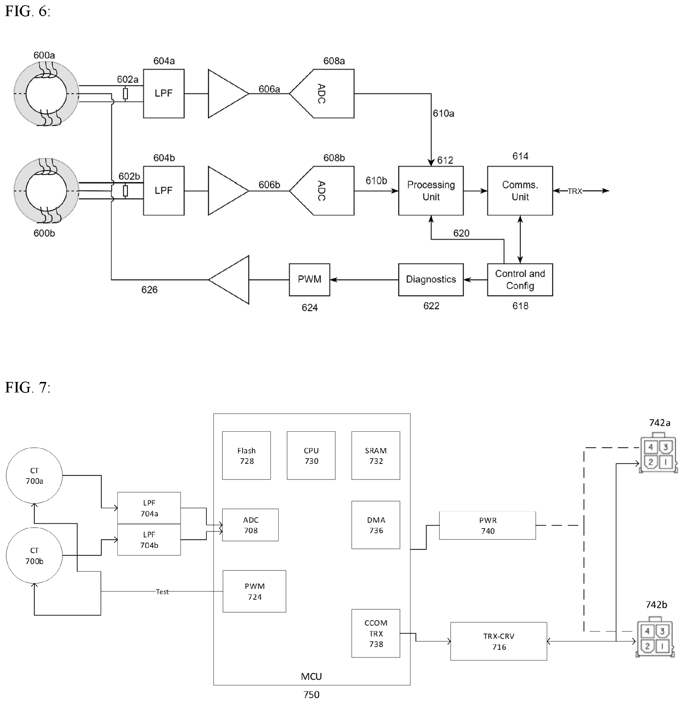

FIG. 6 illustrates one embodiment of a system for monitoring current in an electrical circuit of the present disclosure comprising two current transformers operating simultaneously. Each current transformer is configured to be coupled to the electrical circuit for monitoring and configured to produce an analog current signal. The signal from each current transformer 600a and 600b is converted independently and directed to the processing unit 612. That is, the analog current signal from current transformers 600a/600b are directed to burden resistor 602a/602b and converted to an analog voltage signal. Each analog voltage signal is subjected to a low pass filter and the resulting filtered analog voltage signals 606a/606b are directed to ADCs 608a/608b to produce digital voltage signals 610a/610b. These digital voltage signals are directed to the processing unit 612. The system, including units 614, 616, 618, 620, 622, 624, and 626, otherwise operates in a manner similar to that described in FIG. 4.

A system for monitoring current in an electrical circuit configured in the manner set forth in FIG. 6 is capable of receiving and locally processing two discrete current signals. The local nature of the processing, diagnostics, etc. allows for the system to increase the number of measurable points on the circuit and increase the scalability of methods and systems comprising such systems as described in further detail below.

FIG. 7 shows an alternative configuration of one embodiment of a system for monitoring current in an electrical circuit of the present disclosure comprising two current transformers operating simultaneously.

Similar to the discussion related to FIGS. 5A and 5B, certain embodiments of the system comprise both a current transformer and a MCU 750. The presence of this MCU 750 allows for the system for monitoring current in an electrical circuit to process signals resulting from multiple current transformers, control the communication of such signals, and/or control the subsequent actions taken in response to these signals (e.g., further diagnostic steps described herein).

As illustrated in FIG. 7, the MCU 750 transmits data to and from the system via transceiver 716 and communication buses 742a and 742b. As described in further detail below, data resulting from each of the two current transformers may be synchronized such that all of the data may be sequentially transmitted via a single communications bus.

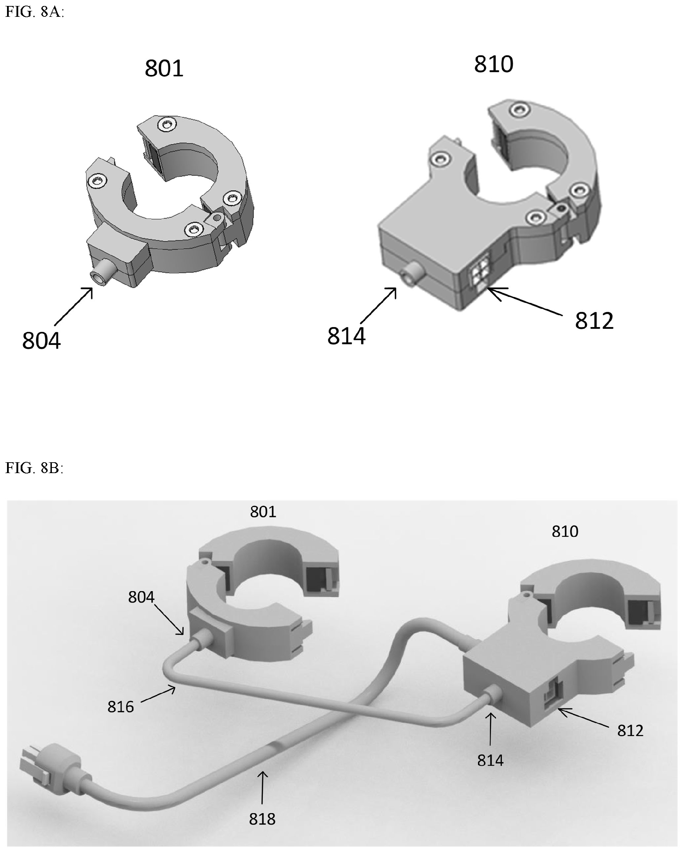

FIGS. 8A and FIG. 8B illustrate an exemplary configurations of systems for monitoring current in an electrical circuit comprising two current transformers.

In embodiments wherein the system comprises two current transformers, the current transformers may be the same or different. As shown in FIG. 8A, a first current transformer 801 comprises a clamp and a connection port 804. A second current transformer 810 comprises a clamp, a connection port 814, and a communication bus 812. In certain embodiments, not shown in these figures, a MCU is embedded within the enclosure of 810. That is, current transformer 801 is a standard current transformer, while unit 810 contains a current transformer and the remainder of the components of a system for monitoring current in an electrical circuit necessary to convert the signals to a digital signal and/or conduct further analysis on the signals as described herein.

In one embodiment, current transformer 801 and 810 are connected via a connection cable. For example, as shown in FIG. 8B at 816, a connection cable may be present linking the connection port 804 to the connection port 814. In this way, current transformer 801 is capable of measuring and transmitting an analog current signal to current transformer 810 for conversion and/or further processing.

The MCU embedded within current transformer 810 may communicate with or transmit data regarding one or both of the current transformers to a second location via communication bus 812. In the embodiment of FIG. 8B, the current transformer 810 also comprises a power cable 818 which is connected to a power source and configured to provided power to current transformers 801 and 810, as may be necessary for signal conversion, analysis, and/or the injection of a test (e.g., common) signal.

This presents numerous advantages over previous systems, where every current transformer secondary required its own pair of wires, and the volume of wires required but such a system may have been prohibitive. In contrast, the configuration of FIG. 8B allows for multiple current transformer measurements to be taken, and the resulting signal(s) to be transmitted along a single wire or communications bus.

In some embodiments, current transformer 801 further comprises circuitry configured to receive the analog current signal and output an analog voltage signal corresponding to the received analog current signal (e.g., a burden resistor). The resulting analog voltage signal is then transmitted to current transformer 810 as described above. In other embodiments, current transformer 801 further comprises conversion circuitry configured to receive the analog current signal and output a digital voltage signal corresponding to the received analog current signal. For example, the conversion circuitry may comprise a burden resistor, a low pass filter, and an ADC. In one embodiment, the system comprises one or both of 801 or 810 converting, by a burden resistor of the conversion circuitry, the measured analog current signal to a corresponding analog voltage signal and converting, by an analog-to-digital converter (ADC) of the conversion circuitry, the analog voltage signal to the corresponding digital voltage signal.

FIG. 9 shows one embodiment of a system for monitoring current in an electrical circuit of the present disclosure comprising two pairs of current transformers operating simultaneously. Each pair of current transformers operate and are configured similar to those described previously in Figures 6-8B.

A pair of current transformers 900a/900b and 1000a/1000b direct their respective measured analog current signals to individual low pass filters. Current transformer 900a to low pass filter 904a, current transformer 900b to low pass filter 904b, current transformer 1000a to low pass filter 1004a, and current transformer 1000b to low pass filter 1004b. The resulting filtered analog voltage signals are directed to ADCs 908/1008 as shown, wherein the ADCs are configured to receive the filtered analog voltage signal and output a digital voltage signal.

As described previously, a MCU 950/1050 may be configured to convert and process the voltage signal, perform diagnostics on the current transformer and/or circuit being measured, independently perform configuration and control of the current transformer, and/or communicate information external to the system (e.g., a monitor at a second location). The embedded MCU may also be configured to receive communications from a source external to the system (e.g., a monitor at a second location), and perform the desired function or step within the system. Each MCU unit 950/1050 comprises an ADC 908/1008, a flash memory 928/1028, CPU 930/1030, SRAM 932/1032, DMA unit 936/1036, transceiver or communications unit 938/1038, and a pulse width modulation unit 924/1024.

Data is transmitted to and from the MCU of the system for monitoring current in an electrical circuit via transceiver 916/1016 and communication buses 942a/942b/1042a/1042b as shown. Power is supplied to the MCU and communication buses via power units 940/1040. As illustrated in FIG. 9, the data from MCU 1050 is transmitted to communication buses 1042a and 1042b. Optionally, this data can be further transmitted to communications busses 942a and/or 942b. The data from MCU 950 is transmitted to communication busses 942a and 942b. The signals from both MCU 950 and 1050 may be ultimately transmitted to communication bus 1142 as shown. As described elsewhere herein, it is one aspect of the present disclosure to utilize multiple current transformers connected to a single communication bus. A monitor or other external device may synchronize the transmission of the multiple signals from the current transformers such that the signals do not overlap and can all be transmitted using a single communications bus.

The embodiment of FIG. 9 allows for multiple measurements of current in an electrical circuit to take place at different locations (i.e. pairs of current transformers 900a/900b and 1000a/1000b attached to different sections of the current (e.g., wire) to be measured).

Having described certain specific configurations and embodiments of the present disclosure, it will be understood that a number of benefits may be realized by operating in the described manner. The present disclosure is directed in one embodiment to a solution for metering devices using current transformers where the digital conversion is done near the current transformer output, resulting in a number of improvements over previously employed methods and systems.

Digital signals reduce the variability and influence of external noise, improve reliability of the measurements and electromagnetic interference/electromagnetic compatibility (EMI/EMC) effects, solve crosstalk issues, and increase the overall accuracy of the measurements that are made. Evaluation of a digital signal also allows for better signal to noise ratio and improved signal integrity.

As the measurements (i.e. signals) are transmitted over a digital communication channel, the communication frame and protocol can provide integrity checks with error correction and detection algorithms implemented in the communication hardware. For example, standard communication channel and protocols such as a transceiver unit (TRX), CAN bus, SPI, T1S-Base10, CAN-FD, Modbus-RT, and/or other physical communication protocols with built-in signal integrity may be employed to allow for error checking and correction in the communication bits. This results in an overall better system integrity. Digital communication can further provide the data (i.e. signals) at different rates and different cables lengths without compromising the accuracy of the underlying measurement. Digital communication also allows for the commissioning of measurements by current transformers to be done automatically, with less configuration and setup time required.

Digital communication permits more than one set of current transformer sensors to be connected in the same communication bus, thereby allowing for an expandable number of measurable points and increased scalability. With scalable sets of current transformer sensors, the systems and methods described herein can use a single communications connection point and reduce the interfaces, space, and cost associated with additional connectors. Reducing the number of connectors or connection points for communication also allows for the installation of monitoring devices (e.g., current transformers or the systems described herein) in a more simplified, faster, and less error prone manner. Importantly, such a simplified installation scheme results in a system more intuitively addressable by electricians.

In embodiments described herein where circuity (e.g., a MCU) is present within the system, the presence of such circuitry allow for customizable processing within the system. For example, the circuity can provide measurements data, waveform raw samples, and other computed features such as THD, RMS measurement points at different rates. The circuity can also have a built-in self-test and diagnostic configuration to detect the state of the current transformer secondary winding, whether the clamps are open, and potential damage to the system.

Where discussion herein is directed to circuitry configured to convert a signal (e.g., conversion circuity), it will be understood that any circuitry capable of performing the desired conversion may be employed. For example, in a certain embodiment the conversion circuitry comprises a burden resistor and ADC. In other embodiment, the conversion circuity comprises a microcontroller or MCU. In still further embodiments, the conversion circuity comprises a processor and a memory coupled to the processor. The memory has computer-executable instructions stored thereon. The instructions, when executed by the processor, cause the processor to perform the desired conversion.

In certain embodiments, the conversion circuity comprises a burden resistor configured to convert the analog current signal to an analog voltage signal, and a microcontroller comprising one or more of: an ADC configured to convert the analog voltage signal to the digital voltage signal; flash memory; a central processing unit; static random-access memory (SRAM); a low-dropout (LDO) voltage regulator; a direct memory access (DMA) unit; a transceiver or communications unit; or a pulse width modulation unit.

Although certain embodiments are discussed herein directed to use of a single current transformer, it will be understood that methods and systems comprising multiple current transformers are also within the scope of the present disclosure. For example, a system for monitoring current in an electrical circuit comprising a plurality of current transformers each configured to be coupled to the electrical circuit for monitoring. In certain embodiments, each of the plurality of current transformers are configured to produce an analog current signal representative of the current in a respective portion of the electrical circuit to which the current transformer is coupled, and the system further comprises conversion circuity configured to receive each analog current signal and output digital voltage signals corresponding to each received analog current signal. Still further, various embodiments are directed to systems wherein the conversion circuity is adjacent to the plurality of current transformers.

While discussion herein is directed, in certain embodiments, to systems for monitoring current in an electrical circuit, it will be understood that the present disclosure is equally applicable to systems for determining a status of an electrical circuit and methods utilizing any of the described systems.

As described elsewhere herein, the current transformers and systems for monitoring current in an electrical circuit may be synchronized with a monitor in a digital manner. Thus, system accuracy (i.e. between the current transformers and monitors) can be maintained even when current transformers are replaced or serviced.

For example, FIG. 10 illustrates communication of a digital voltage signals from multiple Sensor Devices 1102, 1102(n) to one Monitor or Manager Device 1101, wherein the devices are connected in the same communications bus. Throughout the discussion herein related to communication, reference is made to "sensor devices." It will be understood that the sensor devices represent any of the current transformers or systems (e.g., current transformer and conversion circuity) described and illustrated herein. That is, a sensor device may refer to one or more of the described systems for monitoring current in an electrical circuit wherein, for example, the system comprises a current transformer and an ADC configured to receive the analog voltage signal from the current transformer and output a digital voltage signal corresponding to the received analog voltage signal. For example, as illustrated in any of FIGS. 1 and 3-9. Therefore, in certain embodiments, the signal(s) transmitted by these sensor devices correspond to the digital voltage signals discussed elsewhere herein.

As described elsewhere above, the conversion of an analog current signal to a digital voltage signal provides a number of benefits. For example, digital voltage signals can be communicated from multiple devices, wherein the multiple devices are connected to the same communications bus. The communication, analysis, and/or further processing of such signals may be accomplished by one or more hardware and/or software devices and configurations.

In FIG. 10, the signal transmitted by the Sensor Devices 1102 and 1102(n) is a digital voltage signal resulting from the systems for monitoring current in an electrical circuit discussed elsewhere herein (also referenced herein as a "communications output" from each respective sensor device). Although only Sensor Device 1102 and 1102(n) are shown, it will be understood that communication of a digital signal as described allows for any number (i.e. (n) number) of sensor devices to be present within a communications bus. The sensor devices are connected with a Manager Device 1101 using the same bus connection topology and having the power within the same cable supplied from the monitor. The Manager Device 1101 (e.g., manager transceiver) manages the control and synchronization with each Sensor Device 1102/1102(n). For example, in one embodiment, the Manager Device 1101 instructs the current transformers present within each Sensor Device 1102/1102(n) to perform a specified measurement. In other embodiments, the Manager Device 1101 may be configured to synchronize the transmission of signals between the Manager Device 1101 and the Sensor Devices 1102/1102(n), to prevent overlapping transmissions. That is, each Sensor Device 1102/1102(n) is synchronized with the Manager Device 1101 such that it is configured to transmit data measurements at a dedicated time slot to prevent any packet collision within the bus.

Configuration of a bus in such a manner allows for a communication channel to be present which contains built-in integrity checks with the hardware (e.g., current transformers), allows for the discovery of devices connected to the communications bus, permits flexible data rates and transmission frequencies from each sensor device, and allows for each sensor device to provide different types of measurements based on commands from the monitor.

Although the manager device is described herein as synchronizing the sensor devices and signals thereof, the manager device may be configured to perform any additional tasks desired by the operator. In one embodiment, the manager device may also be configured to conduct energy monitoring and/or energy management of the system. For example, by using one or more control algorithms. The manager device may, in other embodiments, be configured to conduct energy monitoring and/or energy management of the system by demand response, time of use, service upgrade avoidance, non-intrusive load disaggregation, fault monitoring, etc. In still further embodiments, the manager device may be configured to measure the common voltage inside of a respective panel.

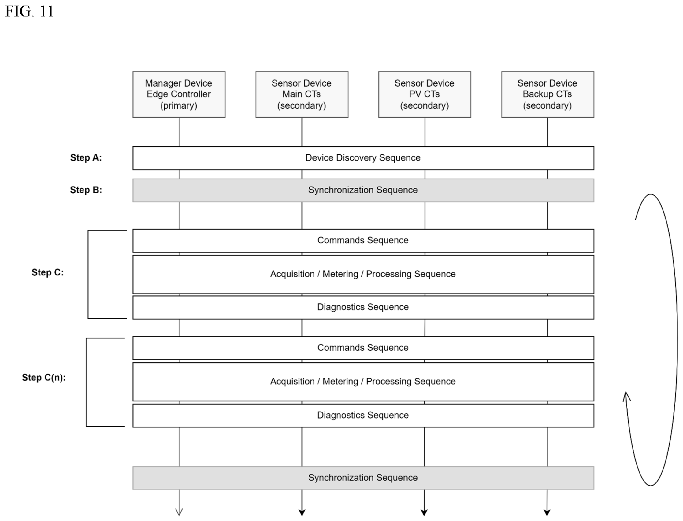

FIG. 11 further illustrates device discovery, synchronization, and waveform sample acquisition across multiple current transformers. In certain embodiments, the current transformers referenced herein may be a sensor device as described above. FIG. 11 provides a sequence for device and signal discovery (Step A), synchronization (Step B), and acquisition, processing, and diagnostics (Step C). In this embodiment, the manager device is an edge controller. The various sensor devices may be used in different locations for monitoring different sources (e.g., solar inverter, backup generator, energy storage device, etc.). For example, a pair of sensor devices may be dedicated to the main source, which forms the connection with the utility grid. Another pair of sensor devices may be connected to additional sources, such as solar panels, backup energy sources (e.g., energy storage battery systems or power generators), etc. All of the devices in this dedicated network have direct connections between manager device (i.e. edge controller, primary) and sensor devices (i.e. end devices, secondary). Therefore, there are no additional delays between manager device to sensor device or sensor device to manager device. Although the diagram and sequences set forth in FIG. 11 illustrates one embodiment, other configurations or sequences may be used, so long as the they are configured to operate in the manner described herein (e.g., discover, synchronize, and send commands for each sensor device to perform signal acquisition, processing, and to report those measurements to the manager device in a periodic cycle).

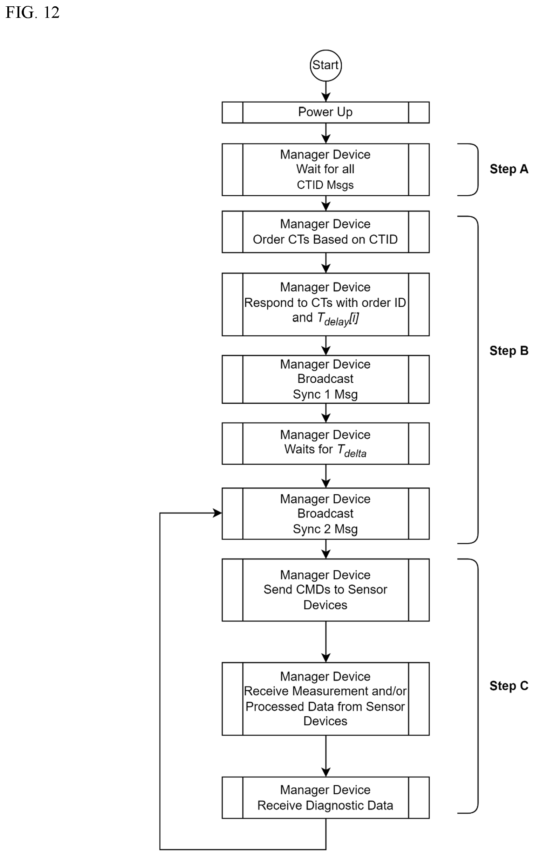

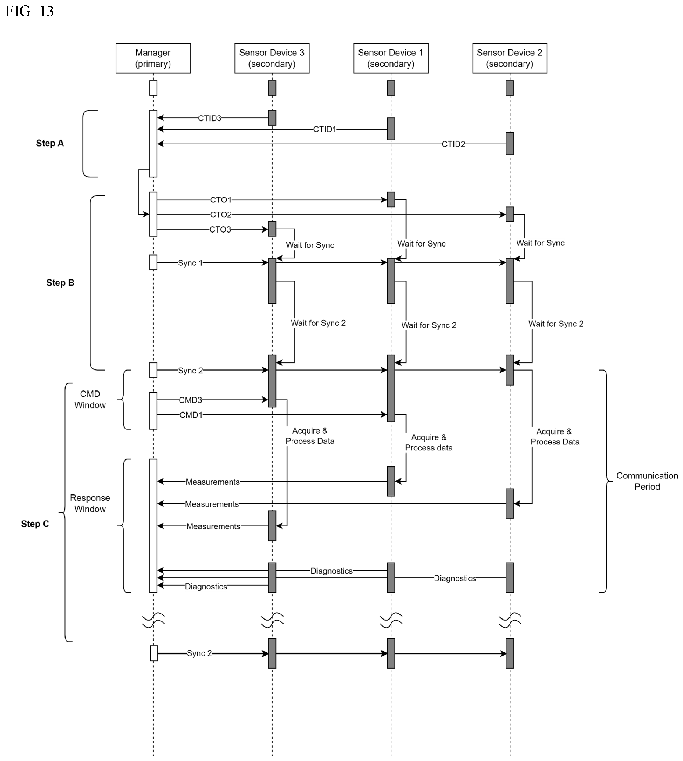

The device discovery, synchronization, and signal processing steps illustrated in FIG. 11 are further illustrated in an exemplary flow diagram of the manager device (FIG. 12) and a data flow diagram between the manager device and sensor devices (FIG. 13).

Beginning with Step A, the manager device begins a device/signal discovery sequence to discover the quantity and identity of the sensor devices are connected to the communication bus. A device discovery sequence may be initiated, for example, when powering on the manager device. Each sensor device will need to identify itself (e.g., transmit a message containing sensor-identifying information). The data or signal transmitted to the manager device identifying the sensor device may be in any form suitable to the manager device. For example, the sensor device(s) may send a message containing sensor-identifying information that contains a serial number that is unique to each device. In other embodiments, the message containing sensor-identifying information may be a CTID message. In still further embodiments, the sensor device(s) may generate a pseudorandom message that identifies the sensor device. The message containing sensor-identifying information are denoted in FIGS. 12 and 13 as "CTID#," wherein the number references the sensor device from which the message originates.

If one or more of the sensor devices are connected to the communications channel for the first time, or the manager device has not previously performed the synchronization procedures discussed herein, there will be collision of the identification data transmitted from one or more of the sensor devices. If such collision occurs, the sensor devices will incur packet losses and need to retransmit their identification signals multiple times.

In certain embodiments, if the sensor device detects a collision of its data, it will continue attempts at communication at predetermined intervals (e.g., after few milliseconds). For example, each sensor device may be configured with a timer and/or random number generator to determine when to next attempt to transmit the message containing sensor-identifying information (e.g., CTID message).

In other embodiments, if any of the sensor devices detects that the communication bus is busy, they may wait to transmit their message until the bus is indicated as free. In certain embodiments wherein each device transmits only when the bus is not busy, one or more of the sensor devices may be configured with a timer and/or random number generator to determine when to send the message containing sensor-identifying information.

In still further embodiments, the sensor device may use pseudorandom generation to determine the timing of when to transmit the message containing sensor-identifying information. For example, the pseudorandom generation may be seeded from the serial number and based on the length of the message (i.e. CTID message), and the next attempts at communication can be determined based on *T_{ctid}*N,* with N being the maximum number of sensor devices that may be allowed to be connected in the communication bus.

In certain embodiments, the manager device may be configured to allow each sensor device a certain window (i.e. set period of time such as 10's of milliseconds) to identify themselves.

Once the message containing the sensor-identifying information from a sensor device is received by the manager device, the manager device responds back immediately with an ACK signal to acknowledge discovery of that specific sensor device. At this point, the sensor device will stop transmitting its sensor-identifying information, thus allowing other sensor devices to increase the likelihood of their success of sending collision-free sensor-identifying information messages.

Once every sensor device has transmitted its sensor-identifying information, received an ACK signal, and stopped transmission of its sensor-identifying information, Step A is complete.

A synchronization sequence of Step B follows the completion of Step A.

Once Step A has been completed and the manager device has received all sensor-identifying information messages (CTIDs) from all of the devices connected to the communications bus (typically within 200-500ms), the manager device sorts the sensor devices' identification in a predetermined order (e.g., ascending or descending order). Once the sensor devices have been sorted, the manager device sends a response to each sensor device based on that order with a known delay T_{delay}. For example, a response to Sensor Device 1 is at 2ms, a response to Sensor Device 2 is at 4ms, etc. This response is denoted in FIG. 13 as "CTO#," wherein the number references the sensor device to which the response message is sent.

Once the manager device has sent all of the response messages (CTOs) to each sensor device, the manager device sends a Sync message to all sensor devices. This Sync message is shown in FIGS. 12 and 13 as "Sync 1." Each sensor device, upon receiving the response message (CTO) from the manager device, resets its internal timer and starts a counter until it receives the Sync 1 message from the manager device. When the Sync 1 message is received, each sensor device will stop their local counter and determine the offset time from receipt of their respective CTO signal to their receipt of the Sync 1 message.

Because this offset time will be different for each sensor device, this offset will allow for an ordering of when each sensor device will transmit their data packets to the manager device. Each sensor device will store this offset time in their non-volatile memory and will use this on subsequent power ups and communications with the Manager device.

During operation, one or more of the sensor devices may be powered off. Upon powering a previously synchronized sensor device on, it may be possible to immediately orient the sensor device. Where the recently powered-on sensor device already has their respective offset time programmed in the non-volatile memory, the sensor device can send the CTID message at the order that has been previously provided by the manager device. The manager device will confirm whether the offset time programed for the sensor device is still valid for the communications bus. If the offset time is valid, the sensor device can operate as normal. If the offset time is no longer valid, the sensor device will need to be integrated into the system as described below.

If a new sensor device is added after the manager device conducts Step A, or if the power of a previously synchronized sensor device is cycled and the offset time is no longer valid, it will be necessary to integrate the device into the system. Each sensor device that requires such integration will undergo the steps as described above to receive a new offset time, which is programmed into the non-volatile memory of the sensor device.

After the sensor devices receive the Sync 1 message and program the offset time into the non-volatile memory of the sensor device, the manager device is able to begin procedures for acquiring and metering the sequence of data from each device.

The manager device waits for a fixed delay before sending a second broadcast Sync message (Sync 2 as shown in FIGS. 12 and 13) to all sensor devices. The fixed delay is shown in FIG. 12 as T_{delta}, wherein T_{delta} represents the transmission period between messages from the manager device. Upon receiving the Sync 2 message, each sensor device determines the time between Sync 1 and Sync 2, which is the time period for transmitting periodic messages ("transmission time"). For example, the transmission time for a given sensor device may be determined based on the formula T_{Sync2} + T_{offset}.

Transmission times can also be specified with one of the commands sent from the manager device directly to the sensor device. In certain embodiments, it may be important to closely control the transmission time of each sensor device. This is particularly true when the transmissions from the sensor devices to the manager device occur at different frequencies, based on the data requested by the manager device. For example, a different transmission time may be required when sending data or information to the manager device at 60Hz vs. 1Hz. In some embodiments, the sensor devices are synchronized based on a known fundamental cycles and the network frequency. For example, the US typically operates at 60Hz and certain global markets operate at 50Hz.

Following establishment of the transmission time for each sensor device, the manager device may send any number of commands to each sensor device to conduct any of the steps or methods described herein (e.g., report data, perform diagnostics, etc.). These commands are shown in FIGS. 12 and 13 as "CMD#," wherein the number indicates the sensor device to which the command is being sent.

If the manager device does not send a command to a given sensor device following the Sync 2 message, each sensor device will respond with a default message or continue following the previous command that might have been sent earlier, at their allocated time window based on the time offset and period.

The process of the manager device sending commands and the sensor devices communicating information to the manager device is shown as Step C.

Following Step C, the manager device may send another Sync 2 message, followed by additional commands.

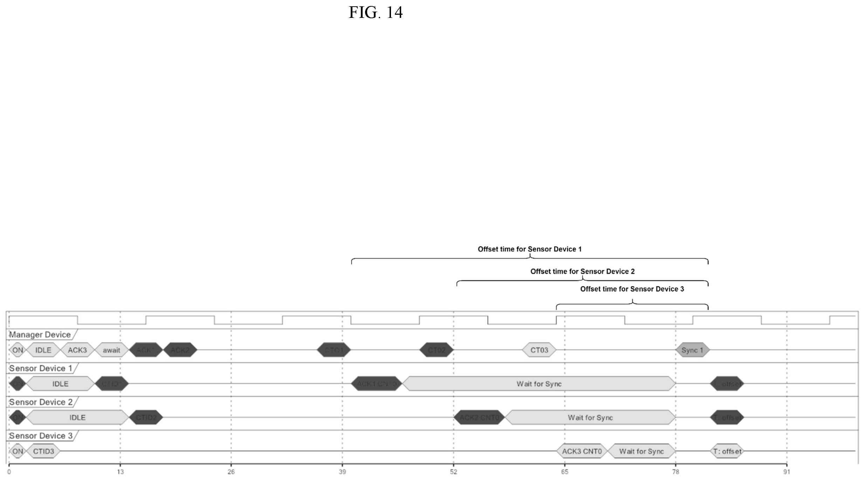

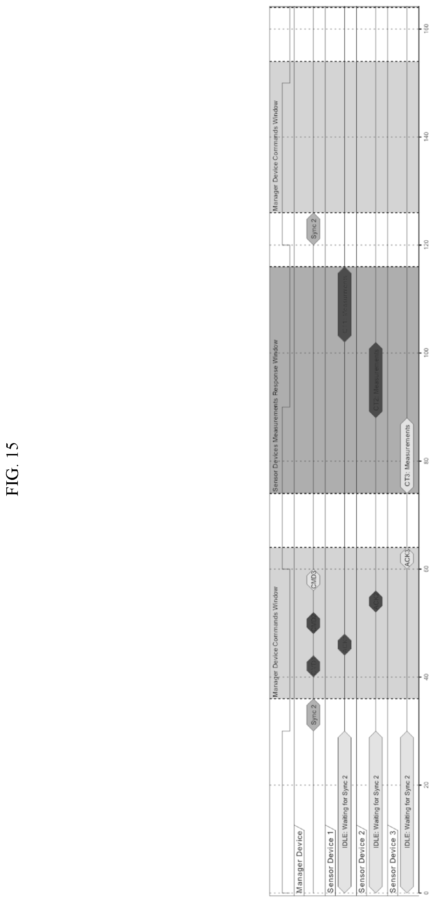

FIGS. 14 and 15 provide alternative illustrations of the above described systems and methods. For example, FIG. 14 illustrates the device discovery and synchronization for three sensor devices, with the offset times show graphically. FIG. 15 illustrates the above described systems and methods further comprising periodic synchronization communications.

Additionally, the manager device can continuously or at set intervals synchronize the clocks of each sensor device and ensure that all sensor devices have not drifted from their set offset time or transmission times.

For example, the manager device may send a sync message every second (1Hz) to synchronize the internal clocks for each sensor device and/or their transmission time. Since each sensor device can provide a timer value from their own internal timers, the manager device will be able to determine if the internal clocks or timer of one or more of the sensor devices has drifted from the desired values. If so, the manager device can provide a sync message at a higher rate than 1Hz. The rate at which the clocks of each sensor device are synchronized can be determined based on evaluation of the sensor device's clock/timer accuracy. In this way, the frequency of these synchronizations can be determined on a device-by-device basis.

Alternatively, the synchronization message may be used to synchronize all the clocks/timers for each sensor device.

In certain embodiments, the manager device can use an external source for synchronization. For example, the zero-cross of the AC line voltage or a clock from the network time protocol from a server.

It is important, in certain embodiments, to keep the manager device and sensor device channels in full synchronization in order to ensure that any voltage and/or current measurements are within the desired degree of accuracy. In other embodiments, it is important to keep the manager device and sensor device channels in full synchronization in order to ensure that any derived measurements, such as power or energy, are within the desired degree of accuracy.

In certain embodiments, time synchronization may also comprise the use of substations. Substations present on the communication network can allow all subsystems to have acquisition clocks aligned for in-sync sampling and accurate measurements, as well as manager devices with multiple end devices.

Although discussion of FIGS. 11-15 is primarily directed to current transformers, it will be understood that the illustrated and described discovery, synchronization, and waveform sample acquisition process and/or configuration may also be utilized with any other suitable device(s). The described systems and methods allow, in certain embodiments, for the synchronization of multiple devices without dedicated hardware, such as T1S-Base10 with time sensitive network (TSN). Therefore, relatively low cost transceiver communication channel(s) can be synchronized with software or methods/configurations described herein without the need for capital costs associated with synchronization hardware.

In some embodiments, a software or hardware data collision mechanisms as described above can be implemented such that more than one digital current transformer subassembly (i.e. a system for monitoring current in an electrical circuit as described herein) can communicate without interfering with other devices in the communication bus. This allows for a single communication interface with the monitor and expansion of measurement points without using dedicated connections in the monitor, but instead using a daisy chain of the current transformers as needed. For example, a T1S bus has a built-in hardware packet collision avoidance and time synchronization configuration. In other embodiments, the transceiver or communications unit (e.g., controller area network with flexible data rate (CAN-FD)) has software synchronization messages that can configure multiple devices to be synchronized and maintains the communication collision avoidance in the firmware.

In certain embodiments, one or more of the devices (i.e. sensor device and/or manager devices) comprise time-sensitive networking (TSN). In other embodiments, one or more of the devices require software implementation to synchronize the device clock.

Embodiments of the aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices.

In operation, processors, MCUs, computers and/or servers may execute the processor-executable instructions (e.g., software, firmware, and/or hardware) such as those illustrated herein to implement aspects of the invention.

Embodiments may be implemented with processor-executable instructions. The processor-executable instructions may be organized into one or more processor executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

Not all of the depicted components illustrated or described may be required. In addition, some implementations and embodiments may include additional components. Variations in the arrangement and type of the components may be made without departing from the scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

Having described the present disclosure in detail, it will be apparent that modifications and variations are possible without departing from the scope defined in the appended claims.

When introducing elements of the present disclosure or the preferred embodiments(s) thereof, the articles "a", "an", "the" and "said" are intended to mean that there are one or more of the elements. The terms "comprising", "including" and "having" are intended to be inclusive and mean that there may be additional elements other than the listed elements.

In view of the above, it will be seen that the several objects of the disclosure are achieved and other advantageous results attained.

As various changes could be made in the above methods, systems, and constructions without departing from the scope of the disclosure, it is intended that all matter contained in the above description and shown in the accompanying drawings shall be interpreted as illustrative and not in a limiting sense.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

Further aspects of the invention are provided by the subject matter of the following clauses:
Clause 1. A system for monitoring current in an electrical circuit, the system comprising: a current transformer configured to be coupled to the electrical circuit for monitoring, wherein the current transformer is configured to produce an analog current signal representative of the current in a portion of the electrical circuit to which the current transformer is coupled; and conversion circuity configured to receive the analog current signal and output a digital voltage signal corresponding to the received analog current signal; wherein the current transformer and conversion circuity are contained within a single enclosure.
Clause 2. The system of Clause 1, wherein the conversion circuity comprises a burden resistor configured to receive the analog current signal and output an analog voltage signal and further comprises an analog-to-digital converter (ADC) configured to receive the analog voltage signal and output the digital voltage signal.
Clause 3. The system of Clause 2, wherein the system further comprises a communications unit configured to output a communications output representative of the digital voltage signal.
Clause 4. The system of Clause 3, wherein the current transformer, the conversion circuity, and the communications unit are contained within the single enclosure.
Clause 5. The system of Clause 3 or Clause 4, wherein the system further comprises a diagnostic unit, and the conversion circuity, communications unit, and diagnostic unit are contained within the single enclosure.
Clause 6. The system of any of Clauses 3 to 5, wherein the system further comprises a monitor configured to receive the communications output and to determine a status of the electrical circuit based on the communications output.
Clause 7. The system of Clause 6, wherein the monitor is configured to provide a diagnostic output in response to the determined status.
Clause 8. The system of any of Clauses 1 to 7, wherein the conversion circuity comprises a microcontroller.
Clause 9. The system of Clause 8, wherein the conversion circuity further comprises a burden resistor configured to convert the analog current signal to an analog voltage signal, and wherein the microcontroller comprises one or more of: an analog-to-digital converter (ADC) configured to convert the analog voltage signal to the digital voltage signal; flash memory; a central processing unit; static random-access memory (SRAM); a low-dropout (LDO) voltage regulator; a direct memory access (DMA) unit; a communications unit; or a pulse width modulation unit.
Clause 10. A method for determining a status of an electrical circuit, the method comprising: sensing, by a current transformer configured to be coupled to the electrical circuit, current in the electrical circuit, wherein the current transformer is configured to produce an analog current signal representative of the current in a portion of the electrical circuit to which the current transformer is coupled; transmitting the analog current signal to conversion circuity configured to receive the analog current signal and output a digital voltage signal corresponding to the received analog current signal, wherein the current transformer and the conversion circuitry are housed in a single enclosure; and transmitting the digital voltage signal to a communications unit, wherein the communications unit outputs a communications output representative of the digital voltage signal.
Clause 11. The method of Clause 10, wherein the current transformer, the conversion circuity, and the communications unit are contained within the single enclosure.
Clause 12. The method of Clause 10 or Clause 11, further comprising: converting, by a burden resistor of the conversion circuitry, the analog current signal to a corresponding analog voltage signal; and converting, by an analog-to-digital converter (ADC) of the conversion circuitry, the analog voltage signal to the corresponding digital voltage signal.
Clause 13. The method of any of Clauses 10 to 12, further comprising transmitting the communications output to a monitor.
Clause 14. The method of Clause 13, further comprising determining, by the monitor, the status of the electrical circuit based on the communications output.
Clause 15. The method of Clause 14, further comprising producing, by the monitor, a diagnostic output in response to the determined status.
Clause 16. A system for monitoring current in an electrical circuit, the system comprising: a plurality of current transformers each configured to be coupled to the electrical circuit for monitoring, wherein each of the plurality of current transformers are configured to produce an analog current signal representative of the current in a respective portion of the electrical circuit to which the current transformer is coupled; and conversion circuity configured to receive each analog current signal and output digital voltage signals corresponding to each received analog current signal; wherein the conversion circuity is adjacent to the plurality of current transformers.
Clause 17. The system of Clause 16, wherein the conversion circuity comprises: one or more burden resistors configured to convert each analog current signal to a corresponding analog voltage signal; and one or more analog-to-digital converters (ADC) configured to convert each analog voltage signal to the corresponding digital voltage signals.
Clause 18. The system of Clause 16 or Clause 17, further comprising one or more communications units configured to output a plurality of communications outputs representative of the digital voltage signals.
Clause 19. The system of Clause 18, wherein the system further comprises a manager device configured to synchronize the communication of each of the plurality of communications outputs along a single communications bus.
Clause 20. The system of Clause 19, wherein the conversion circuity comprises one or more burden resistors configured to convert the analog current signals to analog voltage signals and one or more microcontrollers, wherein each of the one or more microcontrollers comprises one or more of: an analog-to-digital converter (ADC) configured to convert the analog voltage signals to the digital voltage signals; flash memory; a central processing unit; static random-access memory (SRAM); a low-dropout (LDO) voltage regulator; a direct memory access (DMA) unit; a communications unit; or a pulse width modulation unit.

## Claims

1. A system for monitoring current in an electrical circuit, the system comprising:
a current transformer (102) configured to be coupled to the electrical circuit for monitoring, wherein the current transformer (102) is configured to produce an analog current signal (112) representative of the current in a portion of the electrical circuit to which the current transformer (102) is coupled; and
conversion circuity configured to receive the analog current signal (112) and output a digital voltage signal (114) corresponding to the received analog current signal (112);
wherein the current transformer (102) and conversion circuity are contained within a single enclosure (301).

2. The system of claim 1, wherein the conversion circuity comprises a burden resistor (116) configured to receive the analog current signal (112) and output an analog voltage signal (118) and further comprises an analog-to-digital converter, ADC, (106) configured to receive the analog voltage signal (118) and output the digital voltage signal (114).

3. The system of claim 2, wherein the system comprises a communications unit configured to output a communications output representative of the digital voltage signal (114).

4. The system of claim 3, wherein the current transformer (102), the conversion circuity, and the communications unit are contained within the single enclosure (301).

5. The system of claim 3 or claim 4, wherein the system comprises a diagnostic unit, and the conversion circuity, communications unit, and diagnostic unit are contained within the single enclosure (301).

6. The system of any of claims 3 to 5, wherein the system comprises a monitor configured to receive the communications output and to determine a status of the electrical circuit based on the communications output.

7. The system of claim 6, wherein the monitor is configured to provide a diagnostic output in response to the determined status.

8. The system of any of claims 1 to 7, wherein the conversion circuity comprises a microcontroller.

9. The system of claim 8, wherein the conversion circuity comprises a burden resistor (116) configured to convert the analog current signal (112) to an analog voltage signal (118), and wherein the microcontroller comprises one or more of:
an analog-to-digital converter, ADC, (106) configured to convert the analog voltage signal (118) to the digital voltage signal (114);
flash memory;
a central processing unit;
static random-access memory, SRAM;
a low-dropout, LDO, voltage regulator;
a direct memory access, DMA, unit;
a communications unit; or
a pulse width modulation unit.

10. A method for determining a status of an electrical circuit, the method comprising:
sensing, by a current transformer (102) configured to be coupled to the electrical circuit, current in the electrical circuit, wherein the current transformer (102) is configured to produce an analog current signal (112) representative of the current in a portion of the electrical circuit to which the current transformer (102) is coupled;
transmitting the analog current signal (112) to conversion circuity configured to receive the analog current signal (112) and output a digital voltage signal (114) corresponding to the received analog current signal (112), wherein the current transformer (102) and the conversion circuitry are housed in a single enclosure (301); and
transmitting the digital voltage signal (114) to a communications unit, wherein the communications unit outputs a communications output representative of the digital voltage signal (114).

11. The method of claim 10, comprising:
converting, by a burden resistor (116) of the conversion circuitry, the analog current signal (112) to a corresponding analog voltage signal (118); and
converting, by an analog-to-digital converter, ADC, (106) of the conversion circuitry, the analog voltage signal (118) to the corresponding digital voltage signal (114).

12. The method of claim 10 or claim 11, comprising transmitting the communications output to a monitor,
and optionally, determining, by the monitor, the status of the electrical circuit based on the communications output, and optionally producing, by the monitor, a diagnostic output in response to the determined status.

13. A system for monitoring current in an electrical circuit, the system comprising:
a plurality of current transformers (102) each configured to be coupled to the electrical circuit for monitoring, wherein each of the plurality of current transformers (102) are configured to produce an analog current signal (112) representative of the current in a respective portion of the electrical circuit to which the current transformer (102) is coupled; and
conversion circuity configured to receive each analog current signal (112) and output digital voltage signals (114) corresponding to each received analog current signal (112);
wherein the conversion circuity is adjacent to the plurality of current transformers (102).

14. The system of claim 13, wherein the conversion circuity comprises:
one or more burden resistors (116) configured to convert each analog current signal (112) to a corresponding analog voltage signal (118); and
one or more analog-to-digital converters, ADC, (106) configured to convert each analog voltage signal (118) to the corresponding digital voltage signals (114).

15. The system of claim 13 or claim 14, comprising one or more communications units configured to output a plurality of communications outputs representative of the digital voltage signals (114),
and optionally, the system comprises a manager device configured to synchronize the communication of each of the plurality of communications outputs along a single communications bus.
